# EUROPEAN PATENT APPLICATION

(11) **EP 1 244 207 A1**
(43) Date of publication of application: **25.09.2002**
(21) Application number: 01302736.2
(22) Date of filing: 23.03.2001
(51) Int. Cl.: H03D 13/00

(54) **Phase comparator**

(71) Applicant: STMicroelectronics Limited, Almondsbury, Bristol BS32 4SQ (GB)
(72) Inventor: Dellow, Andrew, Strand, Gloucester GL5 3PX (GB)
(74) Representative: Loveless, Ian Mark

(57) **Abstract**

A digital phase comparator circuit determines the relative phase of two digital clock signals derived from the same digital clock. The circuit has two inputs, one connected to each of the clocks to be compared. A latch circuit receives one clock at the clock input, and the other clock at a data input. The latch circuit is arranged so that the output is equal to the signal at the data input when measured at the clock edge. The output is therefore a logic '1' if the second clock leads the first clock, or logic '0' if the second clock lags the first clock. The latch circuit is preferably a D-type flip-flop.

## Description

### FIELD OF INVENTION

The present invention relates to a phase comparator, and in particular to a digital phase comparator.

### BACKGROUND OF THE INVENTION

In digital systems, integrated circuits (ICs) or chips are operated by pulses from a clock. In systems such as television receivers or decrypters, there can be many different chips each operating from one master clock.
For example one master chip may generate a clock internally and present it to the circuit board for use by the other slave chips. In this situation there is a requirement to phase align the clock presented to the circuit board with the one used internally.

One solution of providing this phase alignment is to use an analogue phase comparator and a phase looked loop.

Standard phase comparators handle asynchronous or plesiochronous clocks. Asynchronous clocks are those having no inherent phase relationship, whereas plesiochronous clocks are semi synchronous in the sense that over longer time periods the frequencies and phases are very close, but over shorter time periods one wanders slightly with respect to the other, differing by a few parts per million.

### SUMMARY OF THE INVENTION

We have appreciated that known phase comparators are relatively large and complex. We have further appreciated that a phase comparator can be constructed requiring less die area on a circuit.

Accordingly, there is provided a digital phase comparator circuit arranged to determine the relative phase of two digital clock signals derived from the same digital clock and sampled at different points in a circuit comprising:
- first input connected to a first digital clock terminal at a first point in a circuit;
- a second input connected to a second digital clock terminal at a second point in the circuit;
- a latch circuit arranged to receive the first input at a clock input thereof and the second input at a data input thereof; and
- an output terminal from the latch circuit for producing a signal indicative of the relative phase of the first and second digital clock signals;
- wherein the latch circuit is configured such that the output at the output terminal is equal to the signal at the second input when measured at the clock edge of the signal at the first input, whereby the output is logic '1' if the second clock signal leads the first clock signal and logic 'o' if the second clock signal lags the first clock signal.

We have also appreciated that the phase control of clocks as a result of phase comparison should avoid over correction.

Accordingly, there is provided a digital phase control circuit arranged to determine the relative phase of two digital clock signals, comprising:
- a comparator having two inputs arranged to received two digital clock signals and an output arranged to successively produce a logic 'o' or '1' depending upon the relative phase;
- a counter arranged to receive the output of the comparator and to count the successive occurrences of the logic '0' or '1';
- a programmable threshold store for storing a threshold count value; and
- a shift signal generator for producing a phase shift signal when the counter reaches the threshold count value.

The invention is set out in the independent claims and preferred features set out in the dependent claims to which reference is now directed.

### BRIEF DESCRIPTION OF THE FIGURES

An embodiment of the invention will now be described, by way of example only, in which:
- Figure 1:: shows a clock interface with a phase comparator embodying the invention;
- Figure 2:: shows a comparator embodying the invention;
- Figure 3:: shows the signals for detected phase shifts up and down;
- Figure 4:: shows the phase comparator and shift signal generators in the form of programmable up/down counters;
- Figure 5:: shows the counting action for normal operation;
- Figure 6:: shows the counting action in a 'hunting' operation;
- Figure 7:: shows the up/down counter;

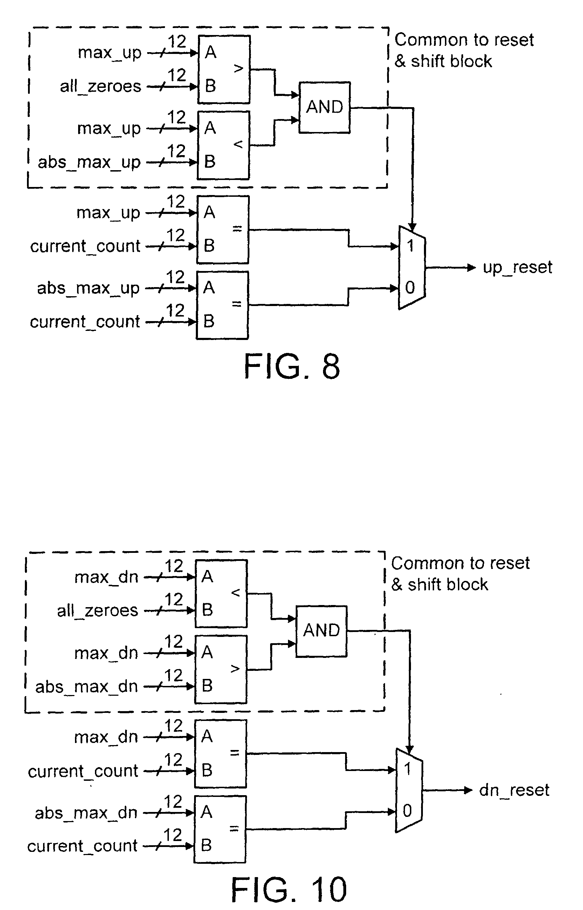

- Figure 8:: shows the reset block of the counter of figure 8;
- Figure 9:: shows the up shift block of the counter of figure 8;
- Figure 10:: shows the reset block for the down counter of figure 8;
- Figure 11:: shows the down shift block of the counter of figure 8;
- Figure 12:: shows the 'OR' function for the reset signals;
- Figure 13:: shows the 'AND' function for the up and down shift signals; and;
- Figure 14:: shows the programmable registers.

### DESCRIPTION OF AN EMBODIMENT

The Digital Phase Comparator is used as part of a clock control system within a device to detect phase difference between an internally used clock and the same clock at an output that is given to other devices for data/control clocking. The clock control system will shift the derived output clock in time so its rising edge is coincident with the internal clock. With the derived clock edge coincident with the internal clock edge, data/control clocked into and out of the device shall be fully phase aligned.

The Digital Phase Comparator module performs the function of phase difference detection between the internal clock and the output clock. It also determines whether or not the external clock edge requires shifting and passes control signals to actual clock edge shifting circuit elsewhere in the device.

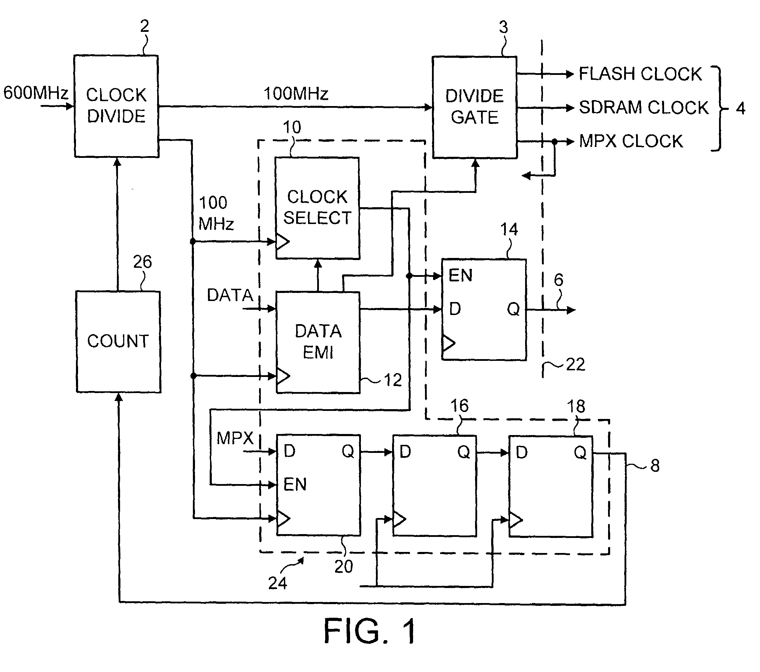

An embodiment of the invention is shown in figure 1 which shows a clock generator and divider circuit 2 providing clock signals at an interface 22 via pins 4 and includes a phase comparator circuit 24 according to the invention.

In digital circuits it is often required to provide clock signals to a circuit board for use by multiple devices, for inter device sommunication. In the example shown, a clock generator and divider 2 operating at 600MHz produces a clock 100 MHz output at pins 4 for a FLASH memory, SDRAM and inter device communication bus (MPX) across an interface 22. The digital phase comparator circuit comprises a D-type flip-flop with enable 20 which has an input taken from one of the output pins 4 (MPX) and the internal clock at 100MHz. The comparator is thus used to detect a phase difference between an internally used clock and the same clock at an output provided to other devices for data control/clocking. The detected phase difference is output at pin 8. In fact for 3 output pins 4 as shown, 3 phase comparator circuits would be provided and are identical to the one shown.

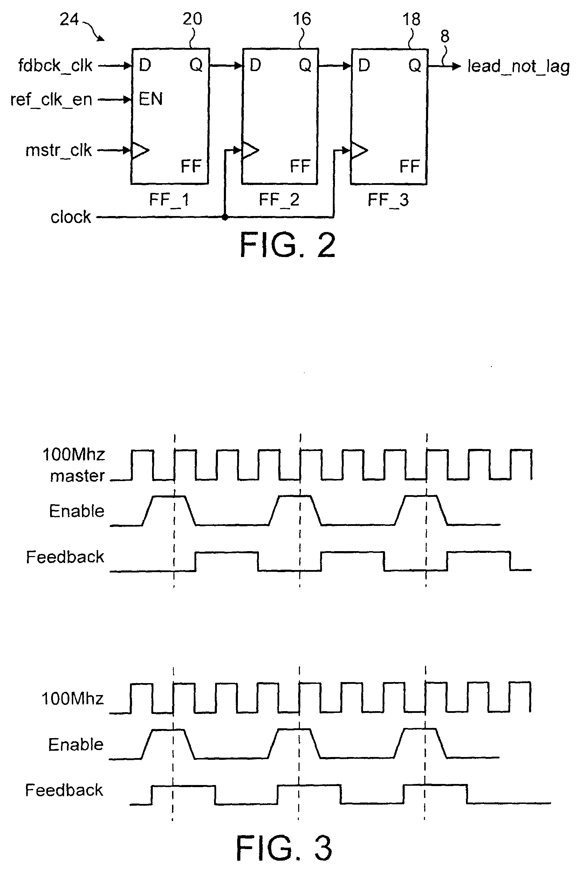

The key element of the phase comparator circuit 24 itself is shown in greater detail in figure 2 and principally comprises a D-type flip-flop with enable FF_1 20 which is arranged in a circuit as shown in figure 1 and has inputs as follows:

| **Signal Name** | **In/Out** | **Function** |
|---|---|---|
| clock | In | Stbus clock. |
| mstr_clk | In | Master clock (100 MHz). |
| ref_clk_en | In | Reference clock. |
| fdbck_clk | In | Feedback clock. |
| lead_not_lag | Out | Lead not lag. |

The comparator is clocked by the master clock input (mstr_clk) so that the output Q is presented every master clock cycle at the clock edge of the master clock 100 MHz. The choice of master clock domains is arbitrary as the output of the circuit is simply 0 or 1 depending upon the phase difference detected. The reference clock input (ref_clk_en) acts as an enable signal so that the feedback clock (fdbck_clk) is sampled every reference clock cycle. The phase difference between the feedback clock (fdbck_clk) and the master clock (mstr_clk) is sampled only when the reference clock is logic '1' and at the master clock rising edge. This will result in either a logic '1' or a logic '0' at the output of FF_1 20 depending on the phase alignment between the feedback clock and the master clock as shown in figure 3. As can be seen, when the feedback clock (fdbck_clk) lags the master clock (mstr_clk), the output of FF1 when sampled at the master clock rising edge will be logic '0'. When the feedback clock (fdbck_clk) leads the master clock (mstr_clk), the output of FF1 sampled at the master clock rising edge will be logic '1'.

In a variant, the enable input (ref_clk-en) need not be present and the clock select 10 not required. In such a variant, the D-type flip flop would correctly produce a phase indication output as described where the clock at the pin 4 is the same frequency as the master clock (here 100 MHz). The feedback clock sampled at the master clock rising edge will either be logic '0' (the feedback lags) or logic '1' (the feedback leads as before). However, the circuit shown in figure 1 preferably includes a dividing gate 3 which simply divides by 1, 2 or 3 to allow the output pins to have clock frequencies 100 MHz, 50 MHz or 33 MHz. To allow for correct comparison of the phase of each of these output frequencies, the enable signal (ref_clk_en) is provided from the clock selector 10.

The reference clock input (ref_clk_en) is an enable signal which is active for a single master clock period and is not necessarily a 50:50 mark:space ratio waveform. The enable signal has the same frequency as the feedback clock, but the feedback clock does have a 50:50 mark:space ratio.

The periodicity of the reference clock pulse is chosen to match the relevant feedback clock and is controlled by the clock selector 10 (figure 1). The clock selector operates by either removing every second clock high, or every third clock high to produce an enable pulse with a pulse width equal to the master clock at it input, but with a periodicity divided by two or three respectively. The periodicity is chosen to match the frequency of the clock output pin for which the phase comparison is being made, and is controlled by the data EMI (External Memory Interface) 10 which also controls the divider 3. Thus, if the frequency at pin 4 is half the master clock (50 MHz) then the enable signal also has periodicity (50 MHz), or if the frequency at pin 4 is a third of the master clock (33 MHz) the enable signal has periodicity 33 MHz. In this way, phase comparison is performed between a master clock at one frequency (100 MHz) and output clocks at other frequencies e.g. 50 MHz, 33 MHz. The operation of the clock select 10 and divide gate 3 are known to the person skilled in the art.

The arrangement of the clock select 10 and divide gate 3 allows phase comparison to be made between the reference and feedback clocks as can be seen in figure 3. The enable pulse at the periodicity of the feedback ensures that the phase is only detected at the frequency of the feedback. Otherwise, a signal would be output at every rising clock edge of the master clock, and would not provide a consistent phase indication.

The lead net lag signal 8 is provided to the clock/frequency divider 2 which is phase controllable in 0.8ns periods (1/2 a clock period at 600 MHz), via a counter clock circuit 26. The counter circuit is provided as a "filter" to ensure that the phase is only controlled as necessary and is described later.

The output of FF1 20 is fed through FF_2 16 and FF_3 18 which is a standard arrangement to clear up the signal and acts as metastability correction and clock synchronisation flops. The actions of FF_2 and FF_3 bring the sampled phase difference back into the bus clock domain. The bus clock domain is used for register writes and up/down counters as will now be described.

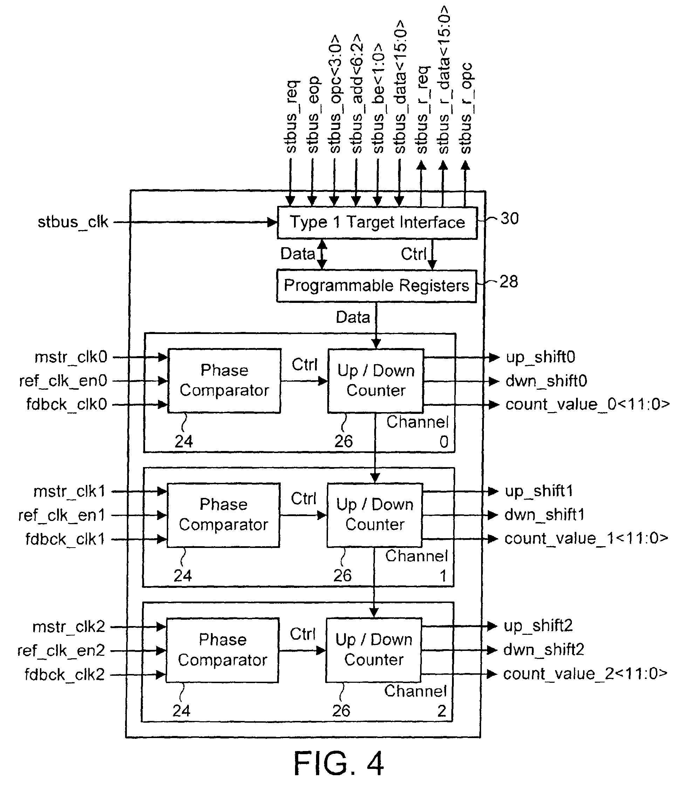

The indication of phase given by the comparator is either logic '0' or logic '1'. This indicates the phase difference. Rather than acting upon this information every bus clock period, however, it is better to determine the extent to which correction is required to prevent over-correction. This is achieved by the circuit of figure 4.

The circuit of figure 4 is a phase comparator and filter combined to provide control signals to alter phase depending upon the comparison. The circuit comprises three channels (one for each feedback clock:- FLASH, MPX, SDRAM) each with a phase comparator 24 and an up/down counter 26. The three channels provide for three different phase comparisons, and for simplicity only one will be described. The circuit also includes programmable registers 28 which receive program data via an interface 30 which operates at a bus clock frequency. The programmable registers provide control data to the up/down counters 26 and thereby allows the counters to be configured for different applications. The programmable registers 28 program the threshold values within the up/down counters 26. The phase comparator 24 provides an up or down count value depending on the relative phase of the reference and feedback clock as previously described. The up/down counter takes the output from the phase comparator and determines whether the clock generator module needs to shift the generated clock pattern (feedback clock) in order to align clock edges. If clock adjustment is required, the relevant up/down output becomes active.

The up/down counter 26 functions as follows. On receipt of the lead not lag signal from the phase comparator, a count is added either to an up count or down count as appropriate. No action is taken until a threshold count is reached, at which point either an up shift or a down shift signal is produced.

The shift signals remain until either the count value reaches a programmable maximum or minimum value, when it and the shift signal are reset, or until the count value counts back below the threshold, when the shift signal is removed.

The counter preferably has 4095 count levels and is symmetrical around the Zero Point. On power-up/reset, the Up/Down counter count value resets to all zeroes (Zero Point). The current count value shall be made accessible by means of a 12 bit output (verification purposes only).

When the count value is within the hysteresis area limits (that is between upper and lower thresholds), both the up_shift and downshift outputs are logic "0". The upper and lower thresholds are programmable. The absolute Maximum Up value is chosen to be +2047, and the absolute Maximum Down value shall be -2047 (-2048 can never be reached due to the fact that the absolute maximum Down value is a 2's complement of the absolute Maximum Up value). The counter counts up/down at a frequency of master clock (mstr_clk) divided by 32, and samples the phase comparator output (lead_not_lag) at a frequency of master clock (mstr_clk) divided by 32.

If the count value is equal to or greater than the Up Count Threshold value, the up_shift output is logic "1" and the downshift output shall be logic "0". Similarly, if the count value is equal to or less than the Down Count Threshold value, the downshift output shall be logic "1" and the up_shift output is logic "0". This controls the phase shifting.

When the count value reaches the maximum upper limit (Max Up Count) any subsequent "count up" signal shall force the count value back to the zero point. Under no circumstances shall the count value be allowed to proceed higher than the programmed maximum upper limit. NOTE: The action of resetting the count value to all zeroes shall force the up_shift output to a logic "0". When the count value reaches the programmed maximum lower limit (Max Down Count) any subsequent "count down" signal shall force the count value back to the zero point. Under no circumstances shall the count value be allowed to proceed lower than the programmed maximum lower limit. NOTE: The action of resetting the count value to all zeroes shall force the downshift output to a logic "0".

If the Maximum Up Count value is programmed to be greater than +2047, the programmed value shall be ignored and the counter shall reset at +2047 (for an up count) or -2047 (for a down count).

If the Up Count Threshold value is programmed to be greater than +2047, the programmed value shall be ignored and the Up Count threshold value shall be set to -2047.

If the count threshold values have been programmed incorrectly such that the up and down count detection ranges overlap, both the up_shift and the downshift outputs shall be logic "0".

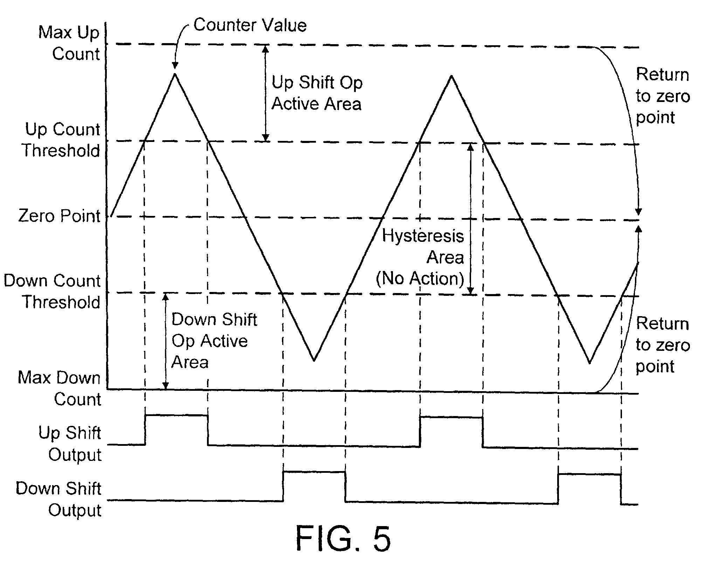

The count values, up count and down count thresholds and maximum and minimum count values are shown in figure 5. As can be seen, if the counter value is above the up count threshold or below the low count threshold then the up shift or down shift output is logic '1' respectively.

The purpose of setting thresholds is as follows. On defecting that phase adjustment is required, the phase detector produces a logic 'o' or logic '1'. If the phase difference persists, this is counted again and again until either the up count or low count threshold is reached. At this point the shift output signal goes high and the phase shift frequency divider moves the phase of the master clock (100 MHz) by one half cycle of its input clock (600 MHz) i.e. = 0.8ns. Some time later the effect of this correction will reach the phase comparator. In the event that the phase now is opposite to its previous position the opposite lead not lag signal is produced and the counter counts to the other threshold, and the phase is moved the other way. Thus the situation figure 5 is reached with phase moving by 0.8 ns either side of phase lock.

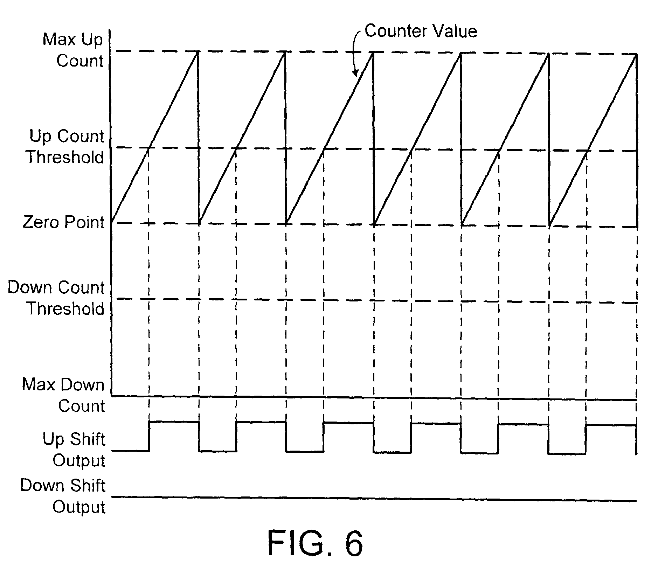

If the phase is not near lock, then the counter will continue in the same direction until the max count is reached. At which point, it returns to zero and continues again and produces a subsequent shift output as shown in figure 6. In this way, the phase is successively shifted in 0.8 ns steps.

The up/down count threshold and max up/down counts are chosen according to the requirements of the circuit.

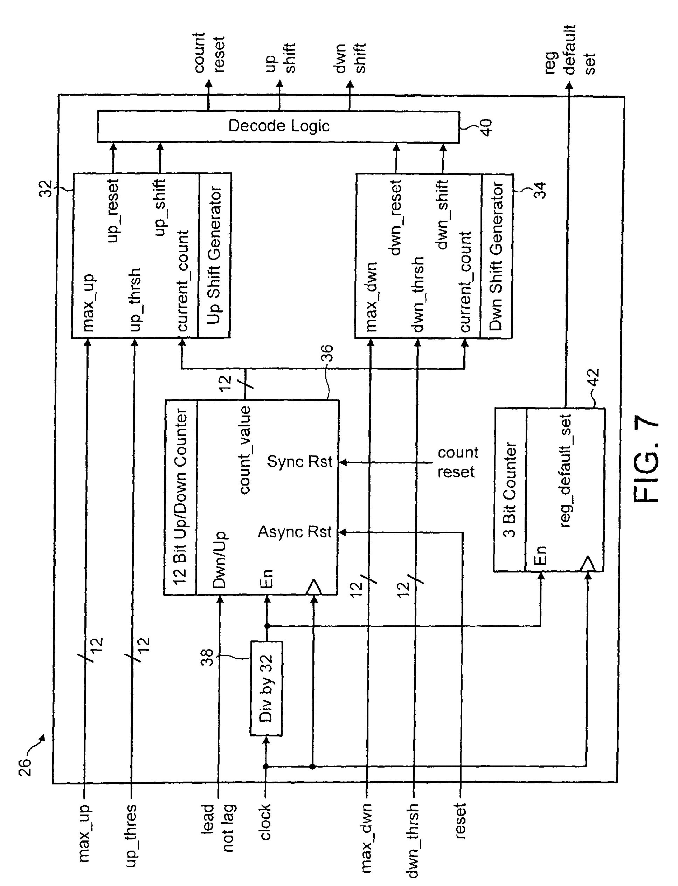

The up/down counter itself could be implemented in a variety of ways and is described for completeness and is shown in greater detail in figure 7 and has the following inputs:

| **Signal Name** | **In/Out** | **Function** |
|---|---|---|
| clock | In | Stbus clock. |
| reset | In | System reset. |
| lead_ not_lag | In | Lead not lag. |
| max_up<11:0> | In | Maximum Up. |
| max_dwn<11:0> | In | Maximum down. |
| up_thrsh<11:0> | In | Up threshold. |
| dwn_thrsh<11:0> | In | Down threshold. |
| up_shift | Out | Up shift. |
| dwn_shift | Out | Down shift. |
| reg_default_set | Out | Controls register setup |

The purpose of the counter, as previously rated, is to determine the time span for which a phase difference is detected and to provide an up or down shift signal, as appropriate, after a predetermined time as set by the up and down threshold valves.

The counter is a 12 bit signed up/down counter with an asynchronous reset. If the sample input(Dwn_not_up) is a logic '0', the counter will count up from its current value. If the sample input is a logic '1', the counter will count down from its current value. When the count value reaches +2047 or -2047, it will automatically reset to 0. The counter is not permitted to rollover from +2047 to +2048 (which is -2048 in reality due to the use of a sign bit) or from -2048 to -2049 (which is +2047 in reality due to the use of a sign bit). Whenever the reset input is active (logic '1') the current count value will be reset to 0 and will remain at 0 until the reset is set inactive (logic '0').

A divider 38 divides the master clock input(mstr_clk) by 32. The divided down output is in the form of an enable signal i.e. active for a single master clock period at the frequency of master clock/32. This is at the same frequency as the ref_clk_en signal for the phase comparator 24.

The Up_Reset signal is generated by an up shift generator 32 by performing logical compares on the following data values. The max up value is compared with zero in order to prevent aliasing of incorrectly programmed down values into the up count range (0 to +2047). The max up value is also compared with the absolute max up value to determine which value should be used as the counters maximum count limit, either the programmed value or the hardware max count limit.

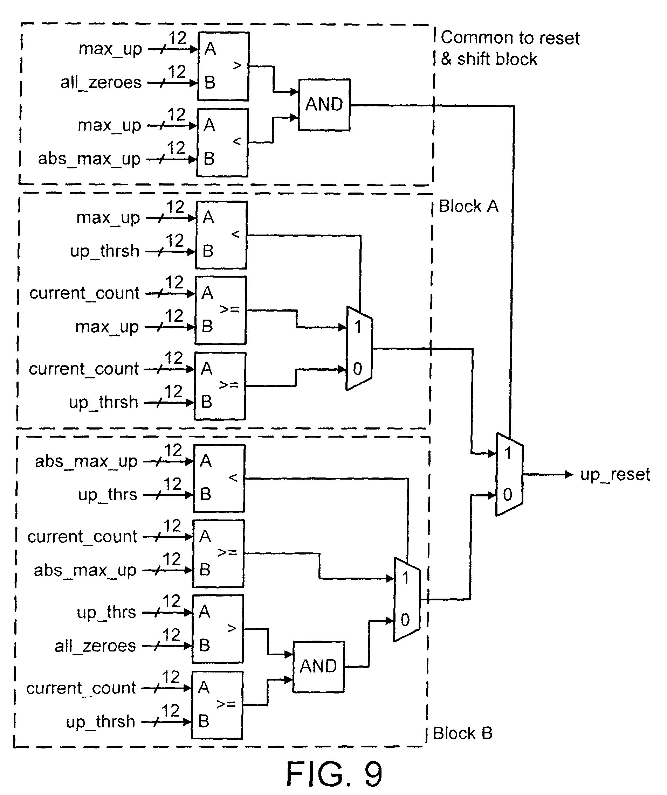

If the lower of the two values is the programmed max up, then a comparison between the programmed value and the current count will ensure that the Up Reset output will be set active when the programmed value is reached. If the absolute max up limit is lower than the programmed max up, then a comparison between the absolute max value and the current count will ensure that the Up Reset output will be set active when the hardware max value is reached. If the programmed value and the absolute max up value are the same then it does not matter which value is used for controlling the Up Reset output, although in reality it will be the absolute max value. The logical circuitry within the shift generator 32 for performing these operations is shown in figure 9.

The Up Shift output is generated by circuitry shown in Figure 9 within the up shift generator 32 in a similar manner to the Up Reset, i.e. by means of data value comparisons. The checking of the programmed max and absolute max is the same as in the Up Reset generation. The outcome of the comparison controls whether the Block A comparison results will drive the Up Shift output or the Block B comparison results. In Block A, the programmed max up value is compared with the programmed threshold value. If the programmed threshold value is less than the programmed max value (expected normal operation) then when the current count value is equal to or greater than the programmed threshold value, the Up Shift output will be set active. In conjunction with this, the Up Reset output would also be set, and the count value would reset to zero on the next counter clock edge, forcing the Up Shift output back inactive.

In Block B, the absolute max value is compared with the programmed threshold value. If the programmed threshold value is less than the absolute max value (expected normal operation), the programmed threshold value is compared with zero in order to prevent aliasing of incorrectly programmed down values into the up count range (0 to +2047). Provided the value has been programmed correctly, when the current count value reaches the value of the programmed threshold, the Up Shift output will be set. If the programmed threshold value is less than zero, the Up shift will be inactive and will remain so until programmed correctly. If the programmed threshold value is greater than the absolute max value then when the current count value reaches the absolute max value, the Up Shift output will be set active. In conjunction with this, the Up Reset output would also be set, and the count value would reset to zero on the next counter clock edge, forcing the Up Shift output back inactive.

The Down_Reset signal is also generated by performing logical compares on various data values. This time within the down shift generator 34. The max down value is compared with zero in order to prevent aliasing of incorrectly programmed up values into the down count range (-2047 to 0). The max down value is also compared with the absolute max down value to determine which value should be used as the counters maximum count limit, either the programmed value or the hardware max count limit.

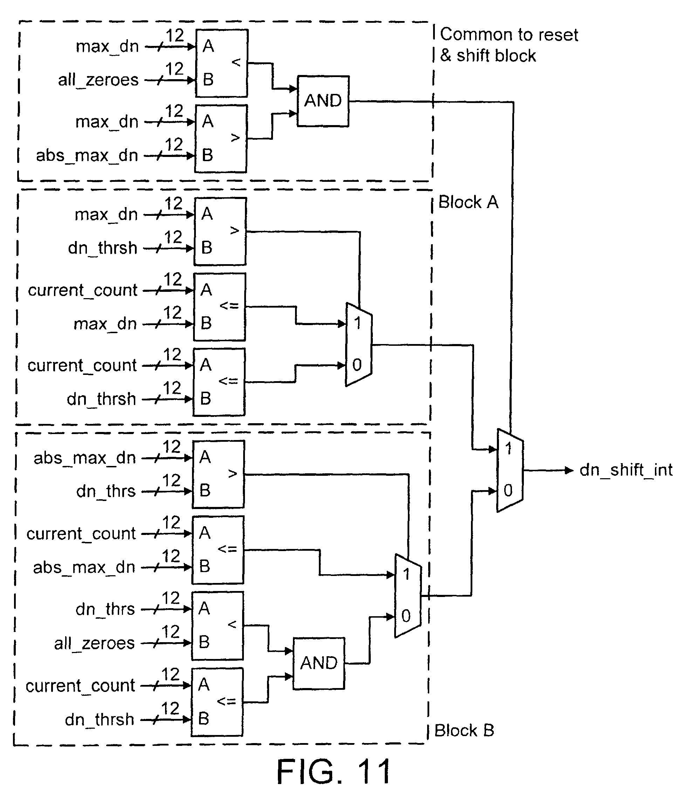

If the higher of the two values is the programmed max down, then a comparison between the programmed value and the current count will ensure that the Down Reset output will be set active when the programmed value is reached. If the absolute max down limit is lower than the programmed max down, then a comparison between the abs max value and the current count will ensure that the Down Reset output will be set active when the hardware max value is reached. If the programmed value and the absolute max down value are the same then it does not matter which is used for controlling the Down Reset output, although in reality it will be the absolute max value. This is shown in figure 10.

The Down Shift output is generated in a similar manner to the Down Reset, i.e. by means of data value comparisons as shown in figure 11. The checking of the programmed max and absolute max is the same as in the Down Reset generation. The outcome of the comparison controls whether the Block a comparison results will drive the Down Shift output or the Block B comparison results. In Block A, the programmed max down value is compared with the programmed threshold value. If the programmed threshold value is greater than the programmed max value (expected normal operation) then when the current count value is equal to or less than the programmed threshold value, the Down Shift output will be set active. If the programmed threshold value was less than the programmed max value, then when the current count value reaches the programmed max value, the Down Shift output would be set active. In conjunction with this, the Down Reset output would also be set, and the count value would reset to zero on the next counter clock edge, forcing the Down Shift output back inactive.

In Block B, the absolute max value is compared with the programmed threshold value. If the programmed threshold value is greater than the absolute max value (expected normal operation), the programmed threshold value is compared with zero in order to prevent aliasing of incorrectly programmed up values into the down count rang e(-2047 to 0). Provided the value has been programmed correctly, when the current count value reaches the value of the programmed threshold, the Down Shift output will be set. If the programmed threshold value is greater than zero, the Down shift will be inactive and will remain so until programmed correctly. If the programmed threshold value is less than the absolute max value then when the current count value reaches the absolute max value, the Down Shift output will be set active. In conjunction with this, the Down Reset output would also be set, and the count value would reset to zero on the next counter clock edge, forcing the Down Shift output back inactive.

The 3 bit counter 42 (figure 7) is used to control register values for a fixed number of clock cycles after reset has been removed. This is so the required up/down threshold values of +1/-1 can be set for the first 4 counter clock cycles. After this time, the register values are set to the expected default values in the Programmable Registers block. This ensure that the phase is shifted initially to allow for the cone when phase is initially 180° out. In this circumstance, the circuit may not generate correctly. Intentionally shifting the phase initially overcomes this problems.

After reset, the reg_default_set output will be logic '0', enabling the counter. With the decode logic set to decode a value of 4 ("100"), the reg_default_set output will be set active when this count value is reached. With reg_default_set being active, the counter can never be enabled again (except by reset), leaving the output set high.

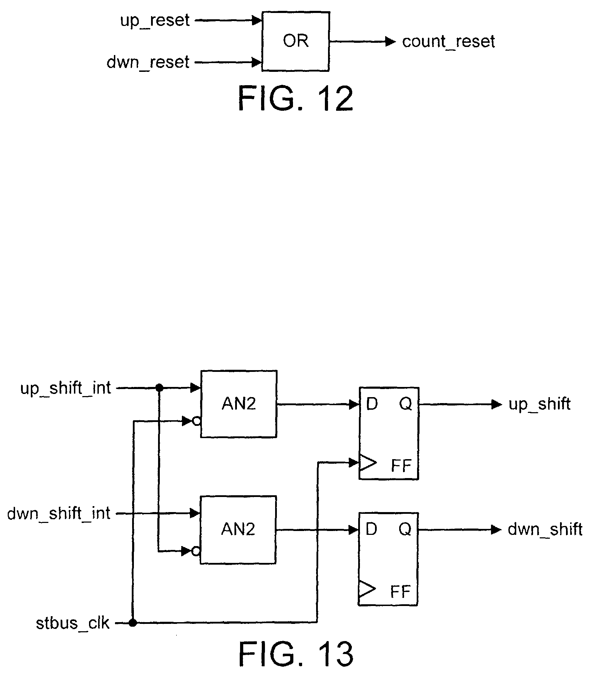

The Decode Logic block 40 (figure 7) contains further logic to take the Up_Reset and Down_Reset signals as well as the up/down shift signals. Within it is a logical OR of the two comparison output reset signals (up_reset and down_reset). These two signals need to be combined as either one can synchronously reset the Up/Down counter. This reset function is independent of the system wide asynchronous reset, and is shown in figure 12.

The shift control logic, as shown in figure 13, prevents both the up_shift and down_shift signals from being active at the same time. If one signal is active, for example up_shift_int = logic '1', the up_shift output would be a logic '1'. Dwn_shift would be prevented from being a logic '1' due to the ANDing with an inverted up_shift_int. If dwn_shift_int were to become active at the same time as up_shift_int were active, then both the up_shift and dwn_shift outputs would be forced to logic '0' and the counter would remain at its current count value. The shift outputs are retimed to stbus_clk before being passed to the external clockgen block ensuring the block output comes straight from a flop rather than decoded combinational logic.

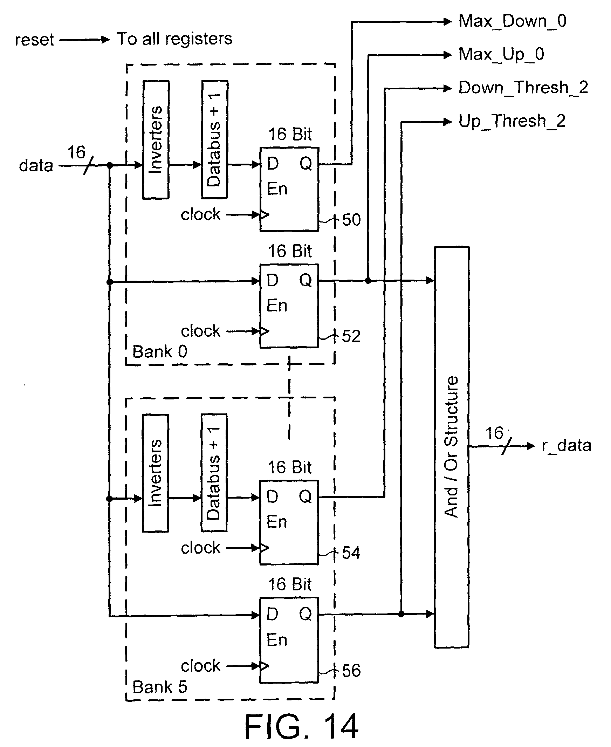

The values at which an up shift or down shift signal is generated are predetermined by the up and down count thresholds. To provide flexibility at the phase comparator, these are preferably programmable as previously described, and for this purpose programmable registers are provided, as shown in figure 14.

In order to maintain the counter symmetry around the zero point, only two programmable register locations 50, 52 are required per channel. These programmable registers shall control the Maximum Count value (up 52 and down 50) and the Count Threshold value (up) 56 and down 54). The programmable registers are clocked at the ST bus clock frequency. The value written to a single register location shall actually be written into two registers occupying the same address location. The value written to the Maximum Count register indicates the count value at which the counter shall reset to the Zero Point after the next "count up" or "count down" command. The value written to the Count Threshold register indicates the count value at which the counter shall assert either the up_shift or the down_shift output. In order to ensure the count value from the Zero Point to the Up Count Threshold value matches the value from the Zero Point to the Down Count Threshold, the register contents for the Down Count Threshold is a 2's complement version of the contents of the Up Count Threshold register. Similarly, in order to ensure the count value from the Zero Point to the Maximum Up Count value matches the value from the Zero Point to the Maximum Down Count, the register contents for the Maximum Down Count is a 2's complement version of the contents of the Maximum Up Count register. As the counter shall count up from 0 to the programmed Maximum Up Count value to indicate an "Up Count", the sign bit is logic "0" (the Up Count Signal).

As the counter shall count down from 0 to the programmed Maximum Down Count value to indicate a "Down Count", the sign bit is logic "1" (the Down Count Signal).

Each single register location actually contains 2 registers, a normal register and a two's compliment register. The normal register output 52, 56 is the value used in the "up" comparison section of the Up/Down Counter, whilst the two's compliment registers 50, 54 output is used in the "down" comparison section of the counter. Therefore when a write to a register address is requested, two simultaneous register writes actually happen. To perform the two's compliment of the data, the databus is initially inverted, and a logic "1" is then added to the least significant bit of the resulting inversion.

The counter maximum and threshold values are thus set in the registers and are symmetrical about '0'. The values can be chosen and programmed as desired for operation of the phase control.

## Claims

1. A digital phase comparator circuit arranged to determine the relative phase of two digital clock signals derived from the same digital clock and sampled at different points in a circuit comprising:
- a first input connected to a first digital clock terminal at a first point in a circuit;
- a second input connected to a second digital clock terminal at a second point in the circuit;
- a latch circuit arranged to receive the first input at a clock input thereof and the second input at a data input thereof; and
- an output terminal from the latch circuit for producing a signal indicative of the relative phase of the first and second digital clock signals;
- wherein the latch circuit is configured such that the output at the output terminal is equal to the signal at the second input when measured at the clock edge of the signal at the first input, whereby the output is logic 'l' if the second clock signal leads the first clock signal and logic 'o' if the second clock signal lags the first clock signal.

2. A digital phase comparator circuit according to claim 1, wherein the latch circuit is a D-type flip-flop.

3. A digital phase comparator circuit according to claim 1 or 2, wherein the latch circuit has an enable input, arranged to receive an enable clock signal having the same periodically as the second clock signal.

4. A digital phase comparator circuit according to any preceding claim, wherein the second clock signal is from the same source as the first clock signal but divided by a divider.

5. A digital phase comparator circuit according to claim 4, further comprising a clock selector for producing an enable clock signal from the first clock signal of the same periodically as the second clock signal for application to an enable input of the latch circuit.

6. A digital phase comparator circuit according to any preceding claim, wherein the latch circuit is a D-type flip-flop and the first input is a master clock frequency, the second input is a reference clock frequency and having an enable input with a periodicity equal to the reference clock frequency.

7. A digital phase comparator circuit according to any preceding claim, wherein the signal indicative of the relative phase is logic 'o' or logic 'l', depending on whether one signal lags or leads the other.

8. A digital phase comparator circuit according to claim 7, further comprising a counter arranged to count occurrences of the signal indicative of relative phase.

9. A digital phase control circuit arranged to determine the relative phase of two digital clock signals, comprising:
- a comparator having two inputs arranged to received two digital clock signals and an output arranged to successively produce a logic '0' or '1' depending upon the relative phase;
- a counter arranged to receive the output of the comparator and to count the successive occurrences of the logic '0' or '1';
- a programmable threshold store for storing a threshold count value; and
- a shift signal generator for producing a phase shift signal when the counter reaches the threshold count value.

10. A digital phase control circuit according to claim 9, wherein the programmable threshold store has an up count threshold and down count threshold.

11. A digital phase control circuit according to claim 10, wherein the up count threshold and down count threshold are equal and opposite.

12. A digital phase control circuit according to claim 9 or 10, further comprising a programmable maximum count store for storing a maximum count value, and wherein the counter is arranged to reset to zero when the maximum count is reached.

13. A digital phase control circuit according to claim 12, wherein the maximum count store has two values, one positive the other negative value for maximum and minimum counts respectively.

14. A digital phase control circuit according to any of claims 9 to 13, wherein the comparator is a digital phase comparator circuit according to any of claims 1 to 8.
